Europäisches Patentamt

European Patent Office

Office européen des brevets

(19)

(11) **EP 0 780 987 A1**

(12) # DEMANDE DE BREVET EUROPEEN

(43) Date de publication:
**25.06.1997 Bulletin 1997/26**

(51) Int Cl.⁶: **H03M 13/00, H04L 27/34**

(21) Numéro de dépôt: **96402748.6**

(22) Date de dépôt: **16.12.1996**

(84) Etats contractants désignés:
**DE ES FI GB IT SE**

(30) Priorité: **19.12.1995 FR 9515053**

(71) Demandeur: **ALCATEL TELSPACE**
**92734 Nanterre Cédex (FR)**

(72) Inventeurs:
- **Fang, Juing**
  **95000 Cergy Pontoise (FR)**

- **Roux, Pierre**
  **95100 Argenteuil (FR)**
- **Houplain, Jean-François**
  **78100 St Germain en Laye (FR)**

(74) Mandataire: **Scheer, Luc et al**
**ALCATEL ALSTHOM RECHERCHE,**
**Intellectual Property Department,**
**30, avenue Kléber**
**75116 Paris (FR)**

(54) **Système de codage/décodage utilisant la modulation MAQ-16 codée en blocs à multiniveaux**

(57)     L'invention propose un schéma de modulation codée en bloc utilisant des techniques de partitionnement multi-niveaux, ce schéma étant transparent aux ambiguïtés de phase de $\pm\pi/2$ et $\pi$, grâce à un codage différentiel et à mapping judicieux, applicable à une modulation MAQ-16, et possédant un gain de codage théorique optimal pour le rendement du code.

Le décodeur associé à ce schéma utilise l'algorithme de Wagner dont la réalisation suppose une complexité très faible comparée à des algorithmes de Viterbi ou de Reed-Solomon.

FIG. 5

EP 0 780 987 A1

**Description**

Le domaine de l'invention est celui du codage et du décodage de signaux numériques et concerne plus précisément un système de codage/décodage utilisant la modulation MAQ-16 codée en bloc à multiniveaux, transparent aux sauts de phase de $\pm \pi/2$ et $\pi$, à rendement de codage élevé et à faible complexité d'implémentation.

La modulation d'amplitude en quadrature à 16 états (MAQ-16) est largement utilisée dans le domaine des faisceaux hertziens compte tenu de son efficacité spectrale élevée (comparée aux modulations de phases ou de fréquence couramment utilisées), et de sa relative simplicité d'implémentation (réalisation du modulateur/démodulateur, traitement du signal, etc.).

D'autre part, dans le cadre des transmissions hertziennes le coût de location des canaux de transmission est directement lié à la largeur du spectre émis. C'est pourquoi le codage de canal choisi pour ce type de liaisons doit avoir un rendement élevé.

Enfin, le codage correcteur d'erreurs doit non seulement présenter des performances acceptables du point de vue système mais encore une complexité d'implémentation la moins élevée possible, surtout pour le décodeur.

Dans le cadre de la présente invention, les données transmises d'un émetteur vers un récepteur sont intégrées dans une structure tramée, à redondance fixe. Dans ce cas, la modulation codée en bloc est préférable à une modulation codée en treillis (TCM en anglais pour 'Trellis Coded Modulation').

Pour une telle transmission, il est connu d'utiliser une modulation et un codage convolutif à haut rendement, séparés l'un de l'autre. Dans le cas d'une structure tramée à rendement fixe (ajout de N bits de redondance aux K bits d'information utile à transmettre), un code en bloc comme celui de Reed-Solomon, en décision ferme, associé à une modulation MAQ-16 est un choix naturel.

Cependant, le choix d'un codage convolutif séparé ou associé à la modulation (codage TCM) implique un rendement nécessairement limité. D'autre part, ce choix ne cadre pas avec celui d'une structure tramée à rendement fixe. Par ailleurs, le décodeur correspondant associé au code convolutif (algorithme de Viterbi) est relativement complexe.

Quant à une modulation associant un mapping MAQ-16 et un codage de Reed-Solomon, un décodeur complexe doit être utilisé. Cette solution ne permet pas, d'autre part, de bénéficier du décodage en décision souple.

Par ailleurs, lorsque la démodulation cohérente est réalisée par un système de récupération de porteuse permettant la synchronisation en phase et en fréquence du signal à la réception, il subsiste, après cette synchronisation, des ambiguïtés de phase qu'il faudra lever. Par exemple, les constellations QPSK et MAQ-n (constellations à deux dimensions) présentent toutes 3 ambiguïtés de phase ($+\pi/2$, $-\pi/2$ et $\pi$) qu'il faut lever. Le schéma de codage sera dit transparent aux ambiguïtés de phase s'il permet de retrouver à la réception la séquence émise quelle que soit l'ambiguïté de phase introduite à la réception par le dispositif de récupération de porteuse.

La présente invention propose un schéma de modulation codée en blocs utilisant des techniques de partitionnement multi-niveaux du type MLC (Multi-Level-Coding), ce schéma étant transparent aux ambiguïtés de phase de $\pm\pi/2$ et $\pi$, grâce à un codage différentiel et à mapping judicieux, applicable à une modulation MAQ-16, et possédant un gain de codage théorique optimal pour le rendement du code. Le codage est de type systématique (les bits d'information utile à transmettre ne sont pas modifiés, seule une information de parité est ajoutée) et le décodeur associé à ce schéma utilise l'algorithme de Wagner dont la réalisation suppose une complexité très faible comparée à des algorithmes de Viterbi ou de Reed-Solomon et fonctionne en décision souple.

Plus précisément, la présente invention concerne un système de codage/décodage utilisant la modulation MAQ-16 codée en blocs à multiniveaux, ce système comprenant un émetteur et un récepteur de bits d'information utile,

- l'émetteur comprenant :

  - deux codeurs par transitions à deux dimensions chacun, un premier des codeurs recevant deux bits d'information utile à transmettre, appelés bits de poids le plus fort, le deuxième des codeurs recevant deux autres bits d'information utile à transmettre, appelés bits de poids le plus faible ;
  - deux codeurs de parité de rendement N/N-1, avec N pair, recevant les bits issus du premier codeur par transitions, les codeurs de parité fournissant tous les N symboles les bits issus du premier codeur par transitions accompagnés d'une information de parité ;
  - une unité d'affectation d'un symbole du plan complexe de la constellation MAQ-16 à chaque groupe de quatre bits issus des codeurs de parité et du deuxième codeur par transitions, l'unité d'affectation fournissant sur deux voies d'émission les niveaux d'amplitude respectifs des symboles tout en respectant les règles suivantes :

    - tous les symboles d'un même quadrant du plan complexe ont les mêmes deux bits de poids le plus faible,
    - les deux bits de poids le plus fort des symboles présents dans le même quadrant et proches d'un même axe du plan complexe différent d'un seul bit, les symboles du plan complexe étant répartis en sous-ensembles, chaque sous-ensemble présentant un couple de bits de poids le plus fort différent du couple de bits de poids le plus fort d'un autre sous-ensemble ;

- des moyens de modulation en quadrature de phase des niveaux d'amplitude fournissant un signal à transmettre ;

• le récepteur comprenant :

- des moyens de démodulation en quadrature de phase du signal reçu, fournissant deux niveaux d'amplitude reçus ;
- une unité de prédécision qui réalise une décision ferme sur les niveaux d'amplitude reçus et qui, pour chacun des niveaux d'amplitude reçus, calcule d'une part un coefficient de fiabilité égal à la différence en valeur absolue entre les distances euclidiennes carrées de chaque niveau d'amplitude reçu et le niveau d'amplitude correspondant au symbole idéal le plus proche dans la constellation MAQ-16, et qui fournit d'autre part une information de secteur permettant de définir dans lequel des trois secteurs délimités par des seuils de décision correspondant à des niveaux d'amplitude idéaux attendus pour les quatre symboles les plus proches des deux axes de la constellation MAQ-16 le symbole reçu se situe ;
- deux décodeurs de Wagner fonctionnant en décision souple et recevant chacun d'une part les décisions fermes correspondant aux bits de poids le plus fort et d'autre part chacun l'un des coefficients de fiabilité, les décodeurs de Wagner fournissant tous les N symboles d'information les décisions fermes accompagnées d'une information de correction indicatrice de la vérification de l'information de parité ;
- une unité de décision recevant les décisions fermes, les informations de correction et les informations de secteur, l'unité de décision corrigeant les deux bits de poids le plus fort issus des décodeurs de Wagner en fonction des informations de correction et corrigeant les deux bits décidés de poids le plus faible en fonction des informations de secteur, des bits corrigés de poids le plus fort et des informations de correction ;
- deux décodeurs par transitions à deux dimensions chacun, un premier des décodeurs recevant les deux bits corrigés de poids le plus fort, le deuxième des décodeurs recevant les deux bits corrigés de poids le plus faible, les décodeurs fournissant des bits reçus et décodés.

La valeur de N est par exemple égale à 16.

D'autres caractéristiques et avantages de l'invention apparaîtront à la lecture de la description suivante d'un mode de réalisation préférentiel, donné à titre illustratif et non limitatif, et des dessins annexés dans lesquels :

- la figure 1 est un schéma synoptique d'un émetteur de signaux comprenant des moyens de codage selon l'invention ;
- la figure 2 représente un exemple de constellation MAQ-16 adaptée au système de codage/décodage selon l'invention ;
- la figure 3 représente le partitionnement en sous-ensembles retenu pour l'obtention de la constellation de la figure 2 ;
- la figure 4 est un schéma synoptique d'un récepteur de signaux comprenant des moyens de décodage selon l'invention ;
- la figure 5 représente des niveaux de décision et des informations de secteur utilisés pour le décodage dans le cadre de la présente invention.

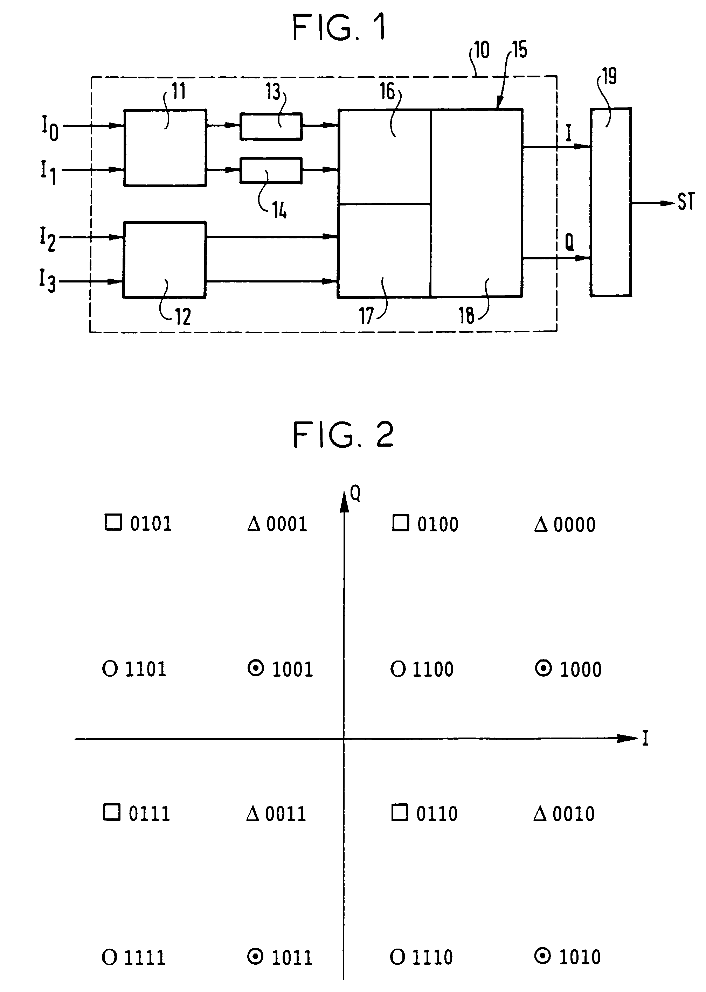

La figure 1 est un schéma synoptique d'un émetteur de signaux comprenant des moyens de codage selon l'invention.

L'émetteur du système de codage/décodage de données numériques selon l'invention comporte des moyens de codage généralement référencés par 10. Ces moyens de codage 10 reçoivent en entrée des bits d'information utile à transmettre $I_0$ à $I_3$ et fournissent sur deux voies d'émission I et Q des niveaux d'amplitude destinés à être transmis.

Les moyens de codage 10 comprennent deux codeurs par transitions 11, 12 (codeurs différentiels) à deux dimensions chacun, un premier des codeurs 11 recevant les bits $I_0$ et $I_1$, le deuxième des codeurs 12 recevant les bits $I_2$ et $I_3$.

Dans la suite de cette description, les bits $I_0$ et $I_1$ sont appelés les bits de poids le plus fort et les bits $I_2$ et $I_3$ sont appelés les bits de poids le plus faible.

A titre d'exemple, les équations de chacun des codeurs différentiels à deux dimensions utilisés sont les suivantes :

$$a_i = (\overline{A_i}.\overline{B_i}.a_{i-1}) + (A_i.\overline{B_i}.\overline{b_{i-1}}) + (A_i.B_i.\overline{a_{i-1}}) + (\overline{A_i}.B_i.b_{i-1})$$

$$b_i = (\overline{A_i}.\overline{B_i}.b_{i-1}) + (A_i.\overline{B_i}.a_{i-1}) + (A_i.B_i.\overline{b_{i-1}}) + (\overline{A_i}.B_i.\overline{a_{i-1}})$$

avec A et B les bits appliqués à l'entrée du codeur différentiel, a et b les bits issus du codeur différentiel, $\overline{X}$ le complément de X, $X_i$ le bit considéré à l'instant t, $X_{i-1}$ le bit considéré à l'instant t-1.

Les bits codés différentiellement issus du codeur 11 sont appliqués à deux codeurs de parité 13, 14 de rendement N-1/N, avec N pair. Chacun des codeurs 13, 14 réalise une sommation modulo 2 de N-1 bits pour calculer une information de parité. Cette information de parité constitue la redondance ajoutée au niveau émission. A titre d'exemple, N vaut 16 et chaque codeur 13, 14 somme 15 bits successifs pour en calculer un seizième égal à la somme modulo 2 des 15 bits précédents. N bits codés sont donc disponibles à la sortie de chacun des codeurs 13 et 14.

De même, N bits sont disponibles à la sortie du codeur différentiel 12.

Les groupes de quadruplets codés sont appliqués à une unité d'affectation 15 qui affecte un symbole du plan complexe de la constellation MAQ-16 à chaque groupe de quatre bits codés. L'unité d'affectation 15 fournit sur les deux voies d'émission I et Q les niveaux d'amplitude respectifs de symboles à transmettre, tout en respectant les règles suivantes :

- tous les symboles d'un même quadrant du plan complexe ont les mêmes deux bits de poids le plus faible,
- les deux bits de poids le plus fort des symboles présents dans le même quadrant et proches d'un même axe du plan complexe différent d'un seul bit, les symboles du plan complexe étant répartis en sous-ensembles et chaque sous-ensemble présentant un couple de bits de poids fort différent.

Ces deux règles correspondent à un mapping de Gray.

La figure 2 représente un exemple de constellation MAQ-16 adaptée au système de codage/décodage selon l'invention. Pour faciliter la compréhension, les différents symboles à transmettre sont représentés par des symboles △, ○, □ et ⊙, à chacun de ces symboles étant affectés quatre bits.

On constate que tous les symboles d'un même quadrant du plan complexe ont les mêmes deux bits de poids le plus faible (00, 01, 11 ou 10) et que les deux bits de poids le plus fort des symboles présents dans le même quadrant et proches d'un même axe du plan complexe différent d'un seul bit. On réalise ainsi une segmentation des symboles du plan complexe en sous-ensembles ('subsets' en anglais).

Cette segmentation en sous-ensembles est plus précisément obtenue à l'aide d'un module 16 de sélection d'un sous-ensemble recevant les bits codés issus des codeurs 13 et 14, d'un module 17 de sélection d'un symbole parmi quatre dans ce sous-ensemble sélectionné, et d'un module 18 de mapping affectant un niveau d'amplitude donné à chacun des différents symboles, pour obtenir une constellation telle que celle de la figure 2.

On notera que l'on peut utiliser d'autres types de mapping respectant les deux règles précédentes, notamment celui consistant à intervertir tous les états logiques 1 et 0 qui fournit une constellation déphasée de 180° par rapport à la constellation de la figure 2.

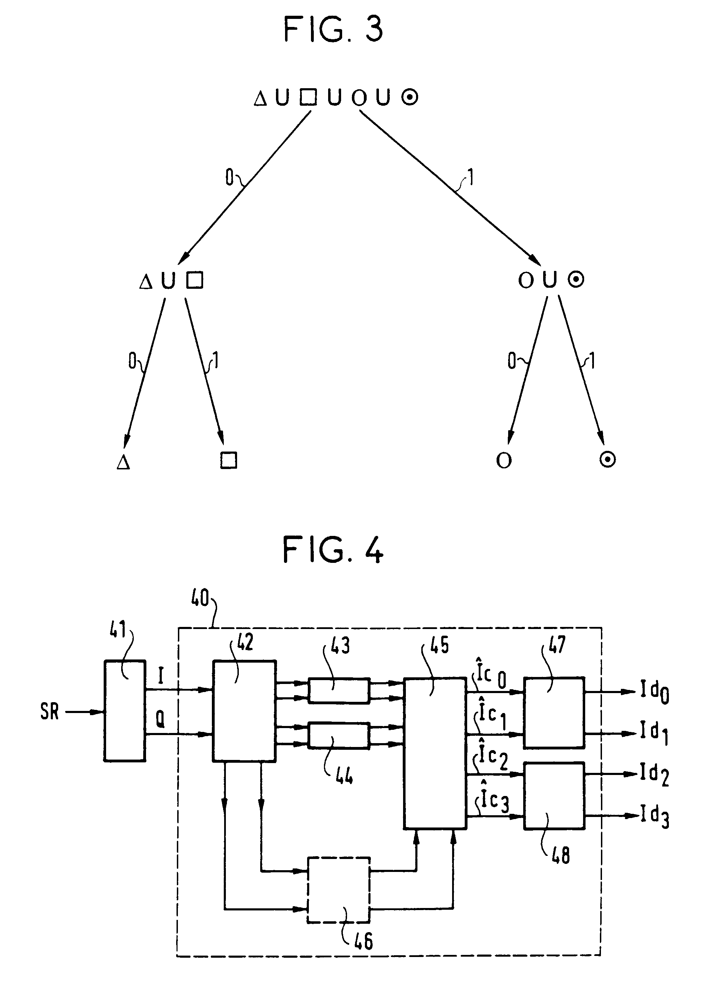

La figure 3 représente le partitionnement en sous-ensembles retenu pour l'obtention de la constellation de la figure 2. Ce partitionnement s'opère dans le module 16.

Le symbole U signifie l'union des différents types de sous-ensembles △, ○, □ et ⊙. Le premier niveau de partitionnement consiste à diviser la constellation en deux ensembles, ici les ensembles des symboles appartenant aux sous-ensembles △ et □ d'une part et les ensembles des sous-ensembles appartenant aux sousensembles ○ et ⊙. Le second niveau de partitionnement consiste à diviser chacun de ces deux ensembles en deux sous-ensembles, afin d'obtenir les quatre sous-ensembles △, □, ○ et ⊙. Ce second niveau de partitionnement permet d'augmenter la distance euclidienne entre les symboles appartenant à un même sous-ensemble.

Il est à noter que le partitionnement en sous-ensembles mis en oeuvre dans la présente invention diffère de celui proposé par Ungerboeck pour le codage TCM en ce que, dans l'invention, la distance verticale (selon l'axe Q) est augmentée par le premier niveau de partitionnement, et la distance horizontale (selon l'axe I) est augmentée par le deuxième niveau de partitionnement, ce qui n'est pas le cas dans le partitionnement d'Ungerboeck.

On peut calculer le gain obtenu par ces deux partitionnements : les distances inter-symboles dans chaque sous-ensemble dans les deux premiers niveaux sont : $\Delta_1^2 = 1$ et $\Delta_2^2 = 1$. Un codage est ensuite réalisé par les deux codes de parité de distance de Hamming 2, afin d'augmenter $d_{free}^2$ à 2 ($d_{free}$ est la distance libre), selon la relation dite du 'lemme de codage multiniveaux' : $d_{free}^2 = \min\{\Delta_i^2 D_H^i\}$, où $\Delta_i^2$ est la distance carrée euclidienne et $D_H^i$ la distance de Hamming du code composant au niveau i. Cette relation caractérise la performance du codage multiniveaux, et est applicable aux cas des modulations codées en blocs.

Pour une évaluation rapide du gain apporté par l'invention, on a dans ce schéma $d_{free}^2 = 2$ et un rendement effectif de codage (nombre de bits d'information utile transmis par symbole d'information) $R_{eff}$ égal à 3,88 bits/symbole (le rendement de codage est égal à (4N-2)/4N, soit 0,97 pour N=16). Le système de référence MAQ-16 non codé a un rendement de 4 Bits/Symbole, et $d_{free}^2 = 1$. On obtient alors un gain de codage $\Delta G$ égal à :

$$\Delta G = 10 \log(R_{eff}d_{free}^{2}) - 10 \log(R_{eff}d_{free}^{2})_{ref}$$
$$= 2{,}8724 \text{ dB}$$

On notera qu'avec un rendement de codage de (4N-2)/4N, le produit $R_{eff}*d_{free}^{2}$ est maximum car le code de parité (N, N-1) a une distance de Hamming égale à 2 qui vérifie la borne de Singleton avec l'égalité D≤N-K+1. Les $\Delta_i^{2}$ sont fixés par le partitionnement en sous-ensembles. Selon le 'lemme de codage multiniveaux' cité ci-dessus, la relation entre la distance libre du schéma global et les distances de Hamming des codes composants, étant données les distances carrées euclidiennes de chaque niveau du partitionnement, la distance libre obtenue est maximale. Par conséquent, le schéma proposé dans la présente invention peut être qualifié d'optimal.

La totale levée des ambiguïtés de phase a été vérifiée par simulations. Ce schéma a un gain de codage (exprimé en Eb/No) d'environ 1 dB pour un Taux d'Erreur Bit (TEB) de $10^{-3}$, de 1,5 dB pour un TEB de $10^{-4}$, et de 2 dB pour un TEB de $10^{-6}$.

La transparence aux ambiguïtés de phase de $\pm\pi/2$ et $\pi$ est visible sur la figure 2 :

- une rotation de phase de 180° implique :
  $\Delta \leftrightarrow \bigcirc$ et $\square \leftrightarrow \odot$ avec '$\leftrightarrow$' signifiant un remplacement,
- une rotation de phase de 90° implique :
  $\Delta \rightarrow \square \rightarrow \bigcirc \rightarrow \odot \rightarrow \Delta$
- et une rotation de phase de - 90° implique :
  $\Delta \leftarrow \square \leftarrow \bigcirc \leftarrow \odot \leftarrow \Delta$ puisque le code de parité (N, N-1) est transparent aux changements $0 \leftrightarrow 1$ si sa longueur N est paire.

Comme ces 4 sous-ensembles sont codés en mapping de Gray, le codage différentiel à 2 dimensions supprime ces 3 ambiguïtés de phase. Les sous-ensembles $\square$, $\bigcirc$, et $\odot$ étant tournés par rapport au sous-ensemble $\Delta$, un deuxième codage différentiel doit être appliqué aux bits $I_2$ et $I_3$.

Le rendement de codage est Rc = (4N-2)/4N, soit (4N-2)/N bits/symbole en supposant que deux bits de parité sont ajoutés tous les 15,5 symboles pour N=16. Le rendement effectif est d'autant plus important que N est grand. Quelque soit la longueur N, avec N pair, le gain de codage asymptotique et l'architecture du codeur et du décodeur qui sera décrit par la suite restent inchangés.

De retour à la figure 1, les niveaux d'amplitude I et Q sont appliqués à des moyens de modulation 19 en quadrature de phase fournissant un signal à transmettre ST. Ce signal ST est transmis, par exemple par voie hertzienne, à un récepteur tel que celui représenté à la figure 4.

La figure 4 est un schéma synoptique d'un récepteur de signaux comprenant des moyens de décodage selon l'invention.

Le récepteur comprend des moyens de décodage généralement référencés par 40. Ces moyens de décodage 40 reçoivent deux trains en bande de base I et Q de moyens de démodulation 41 en quadrature de phase du signal reçu SR, les trains en bande de base correspondant à deux niveaux d'amplitude reçus, et fournissent en sortie quatre bits reçus et décodés $Id_0$ à $Id_3$ correspondant en l'absence d'erreur aux bits $I_0$ à $I_3$ de la figure 1.

Les moyens de décodage 40 comportent une unité de prédécision 42 qui réalise notamment une décision ferme sur les niveaux d'amplitude reçus I et Q, c'est à dire décide, à chaque temps symbole, de la position d'un symbole dans la constellation MAQ-16 en fonction des niveaux d'amplitude I et Q. Cette prédécision s'effectue notamment sur la base des bits $I_0$ et $I_1$ reçus pour déterminer auquel des sous-ensembles précédemment définis appartient le symbole reçu. L'unité 42 fournit également, pour chacun de ces niveaux d'amplitude reçus, d'une part un coefficient de fiabilité et d'autre part une information de secteur.

Un coefficient de fiabilité est la différence en valeur absolue entre les distances euclidiennes carrées du niveau d'amplitude reçu (I ou Q, et noté $\underline{r}$ de manière générale) et le niveau d'amplitude correspondant au symbole idéal le plus proche dans la constellation MAQ-16. Ce coefficient de fiabilité permet de connaître à chaque temps symbole la fiabilité de la décision prise sur le symbole décidé, en tenant compte des quatre bits qui le caractérisent.

Une information de secteur permet de définir dans lequel des trois secteurs délimités par des seuils de décision correspondant à des niveaux d'amplitude idéaux attendus pour les quatre symboles les plus proches des deux axes de ladite constellation MAQ-16 le symbole reçu se situe.

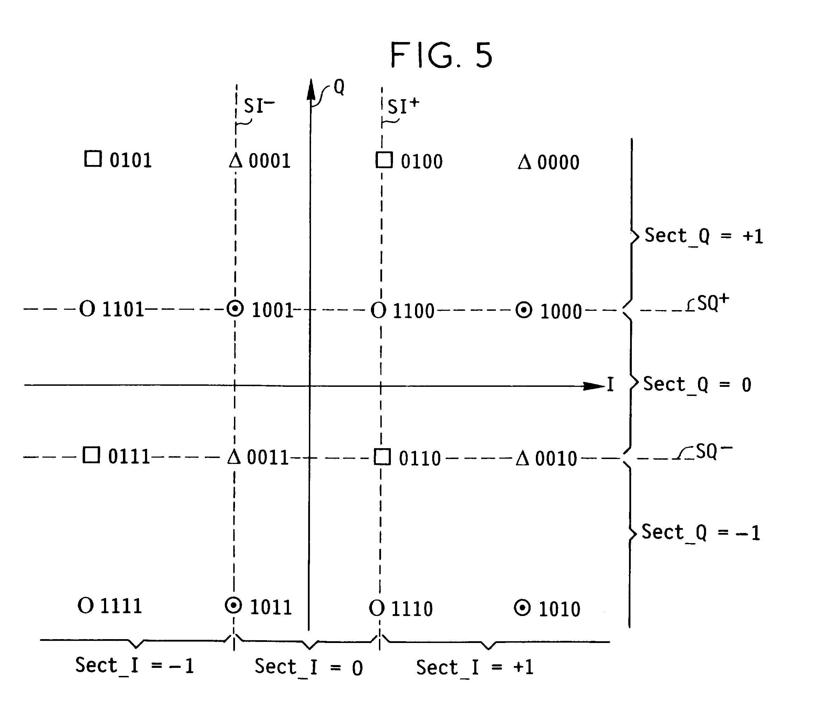

Ces seuils de décision ainsi que les informations de secteur sont représentés sur la figure 5.

Les seuils de décision sont ici référencés $SI^-$, $SI^+$ pour l'axe I et $SQ^-$ et $SQ^+$ pour l'axe Q. A titre d'exemple, les niveaux de seuil $SI^-$ et $SQ^-$ correspondent à une amplitude normalisée de -0,5, les niveaux de seuil $SI^+$ et $SQ^+$ correspondant à une amplitude normalisée de +0,5. Dans ce cas, les niveaux d'amplitude maximums attendus sont idéalement de $\pm 1,5$ sur les deux axes. Les secteurs délimités comme précédemment indiqué sont appelés Sect_I et Sect_Q.

On leur affecte ici les valeurs 0, +1 ou -1 et ils divisent la constellation en neuf zones, chaque zone comprenant quatre points de la constellation.

La fiabilité est la différence, en valeur absolue, des distances euclidiennes carrées entre le signal reçu, $\underline{r}$, et les deux points les plus proches dans la constellation. Il n'y a que 3 possibilités (a, b et c), examinées ci-après pour le niveau d'amplitude reçu sur la voie I, avec $f_i^I$ le coefficient de fiabilité et Sect_I le secteur correspondant :

a) si $-0,5 \leq I < 0,5$, alors $f_i^I = |I|$ et Sect_I=0
b) si $I \geq 0,5$, alors $f_i^I = |I-1|$ et Sect_I = +1
c) si $I \leq -0,5$, alors $f_i^I = |I+1| = ||I|-1|$ et Sect_I= -1

Pour la voie Q, un coefficient de fiabilité $f_i^Q$ est calculé de la même manière et on obtient donc le coefficient de fiabilité $f_i^Q$ et le secteur Sect_Q.

Tout point reçu $\underline{r}$ se trouve nécessairement dans un de ces 9 secteurs, et est décodé en l'un des 4 points de ce secteur. Le fait que les voies I et Q sont indépendantes simplifie le calcul des coefficients de fiabilité.

Les décisions fermes précitées pour les deux bits de poids le plus fort et les coefficients de fiabilité sont appliqués à deux décodeurs de Wagner 43, 44 fonctionnant en décision souple et destinés à participer à la détermination du sous-ensemble optimal auquel appartient le symbole reçu. Plus précisément, chaque décodeur de Wagner 43, 44 reçoit les décisions fermes sur les bits $I_0$ et $I_1$, notées $\hat{I}_0$ et $\hat{I}_1$, et un coefficient de fiabilité. Chaque décodeur de Wagner fonctionne pour l'une des voies, I ou Q, et fournit des valeurs binaires estimées bloc par bloc, ainsi qu'une information de correction.

Un décodeur de Wagner fonctionne de la manière suivante : si les bits $\hat{I}_0$ et $\hat{I}_1$ qu'il reçoit vérifient la relation de parité calculée au niveau des codeurs de parité 13 et 14 de la figure 1, il fournit en sortie une information de correction, appelée 'Wagner_corr_I' ou 'Wagner_corr_Q' en fonction de l'axe qu'il traite, égale à 0. Si en revanche les symboles $\hat{I}_0$ et $\hat{I}_1$ qu'il reçoit ne vérifient pas la relation de parité, il fournit une information de correction 'Wagner_corr_I' ou 'Wagner_corr_Q' opposée, égale à 1.

Les informations de correction s'effectuent tous les N symboles puisqu'il y a lieu de tenir compte de l'information de parité introduite au niveau du codeur (Fig.1). Si 'Wagner_corr_I' = 1, il y a eu une erreur sur l'axe I, et si 'Wagner_corr_Q' = 1 il y a eu une erreur sur l'axe Q.

L'algorithme de Wagner est un algorithme de décodage très simple fonctionnant en décision souple et adapté au décodage de codes comprenant des bits de parité.

Les informations de correction, les bits décidés $\hat{I}_0$ à $\hat{I}_3$, et les informations de secteur sont appliquées à une unité de décision 45. Les informations de secteur provenant de l'unité de prédécision 42 transitent éventuellement par une unité de retard 46 facultative et représentée en traits discontinus. Les bits décidés $\hat{I}_2$ et $\hat{I}_3$ transitent également par l'unité 46, celle-ci apportant un retard correspondant au temps mis par les décodeurs de Wagner 43, 44 pour traiter les signaux qu'ils reçoivent.

L'unité de décision 45 a deux fonctions de demapping :

-i- elle corrige les deux bits de poids le plus fort décidés $\hat{I}_0$ et $\hat{I}_1$ en fonction des informations de correction ;
-ii- elle corrige les deux bits décidés de poids le plus faible $\hat{I}_2$ et $\hat{I}_3$ en fonction des informations de secteur, des deux bits corrigés de poids le plus fort à l'étape -i- et des informations de correction.

L'étape -i- peut également être effectuée dans les décodeurs de Wagner 43 et 44 au lieu d'être effectuée dans l'unité de décision 45.

L'algorithme de demapping est décrit ci-dessous.

En considérant tout d'abord les deux bits décidés $\hat{I}_0$ et $\hat{I}_1$ (étape -i-), le demapping est le suivant :

- si 'Wagner_corr_Q' = 1, on a eu une rotation $\triangle \cup \square \leftrightarrow \bigcirc \cup \odot$
   alors $\hat{I}c_0 = \hat{I}_0 \oplus 1$ avec $\oplus$ l'opérateur Ou-Exclusif et $\hat{I}c_0$ la valeur du bit de poids le plus fort corrigé ;

- si 'Wagner_corr_I' = 1, on a eu soit une rotation $\triangle \leftrightarrow \square$, soit une rotation $\bigcirc \leftrightarrow \odot$
   alors $\hat{I}c_1 = \hat{I}_1 \oplus 1$ avec $\hat{I}c_1$ la valeur du deuxième bit de poids le plus fort corrigé ;

- si 'Wagner_corr_Q'=1 et 'Wagner_corr_I' = 1, on a eu soit $\triangle \leftrightarrow \odot$, soit $\bigcirc \leftrightarrow \square$
   alors $\hat{I}c_0 = \hat{I}_0 \oplus 1$ et $\hat{I}c_1 = \hat{I}_1 \oplus 1$

De manière générale, conformément à l'utilisation connue de l'algorithme de Wagner, la valeur du bit le moins fiable est changée lorsqu'une erreur de parité est détectée. Cette détection d'erreur de parité est positive lorsqu'un nombre impair d'erreur s'est produit lors de la transmission du fait du bruit.

Pour le demapping des bits de poids le plus faible $\hat{I}_2$ et $\hat{I}_3$ (étape -ii-), les informations utiles sont (Sect_I, Sect_Q), ($\hat{I}c_0$ et $\hat{I}c_1$) et (Wagner_corr_I, Wagner_ corr_Q). On calcule alors des bits d'erreur ($E_2$, $E_3$) pour corriger les bits de poids le plus faible $\hat{I}_2$ et $\hat{I}_3$ en faisant ($\hat{I}c_2$, $\hat{I}c_3$) = ($\hat{I}_2$, $\hat{I}_3$) $\oplus$ ($E_2$, $E_3$), avec $\hat{I}c_2$ et $\hat{I}c_3$ les valeurs des bits corrigés de poids le plus faible.

Les corrections sur $\hat{I}_2$ et $\hat{I}_3$ sont résumées dans les 3 tableaux suivants :

Pour le tableau 1, 'Wagner_corr_I' = 1 et 'Wagner_corr_Q' = 0. Les valeurs de ($E_2$, $E_3$) correspondant à Sect_I et Sect_Q sont alors :

TABLEAU 1

| Sect_I, Sect_Q | $E_2$, $E_3$ |
|---|---|
| -1, -1 | 0, 0 |
| -1, 0 | 0, 0 |
| -1, 1 | 0, 0 |
| 0, -1 | 1, 0 |
| 0, 0 | 1, 0 |
| 0, 1 | 1, 0 |
| 1, -1 | 0, 0 |
| 1, 0 | 0, 0 |
| 1, 1 | 0, 0 |

Pour le tableau 2, 'Wagner_corr_I' = 0 et 'Wagner_corr_Q' = 1. Les valeurs de ($E_2$, $E_3$) correspondant à Sect_I et Sect_Q sont alors :

TABLEAU 2

| Sect_I, Sect_Q | $E_2$, $E_3$ |
|---|---|
| -1, -1 | 0, 0 |
| -1, 0 | 0, 1 |
| -1, 1 | 0, 0 |
| 0, -1 | 0, 0 |
| 0, 0 | 0, 1 |
| 0, 1 | 0, 0 |
| 1, -1 | 0, 0 |
| 1, 0 | 0, 1 |
| 1, 1 | 0, 0 |

Pour le tableau 3, 'Wagner_corr_I' = 1 et 'Wagner_corr_Q' = 1. Les valeurs de ($E_2$, $E_3$) correspondant à Sect_I et Sect_Q sont alors :

TABLEAU 3

| Sect_I, Sect_Q | $E_2$, $E_3$ |
|---|---|
| -1, -1 | 0, 0 |
| -1, 0 | 0, 1 |
| -1, 1 | 0, 0 |
| 0, -1 | 1, 0 |
| 0, 0 | 1, 1 |
| 0, 1 | 1, 0 |

TABLEAU 3   (suite)

| Sect_I, Sect_Q | $E_2$, $E_3$ |
| --- | --- |
| 1, -1 | 0, 0 |
| 1, 0 | 0, 1 |
| 1, 1 | 0, 0 |

En notant '0' pour Sect_1 = 0, et '1' pour Sect_I = 0 ou Sect_I = -1, et de même pour Sect_Q, on observe que les corrections sur $(\hat{I}c_2, \hat{I}c_3) = (\hat{I}_2, \hat{I}_3) \oplus (E_2, E_3)$ données par $E_2$, $E_3$ sont devenues deux fonctions Booléennes simples :

$$E_2 = (Sect\_Q \oplus 1)*'Wagner\_corr\_Q'$$

$$E_3 = (Sect\_I \oplus 1)*'Wagner\_corr\_I'$$

On notera au passage qu'il suffit de référencer les numéros de secteur par deux bits (0 ou 1) seulement pour les 9 secteurs de la constellation :

- si $-0,5 \leq I < 0,5$, alors Sect_I = 0, sinon Sect_1 = 1, et
- si $-0,5 \leq Q < 0,5$, alors Sect_Q = 0, sinon Sect_Q = 1.

Les bits corrigés $\hat{I}c_0$ à $\hat{I}c_3$ issus de l'unité de décision 45 sont alors appliqués à deux décodeurs par transitions 47, 48 à deux dimensions chacun, un premier 47 des décodeurs recevant les deux bits corrigés de poids le plus fort $\hat{I}c_0$ et $\hat{I}c_1$, le deuxième 48 des décodeurs recevant les deux bits corrigés de poids le plus faible $\hat{I}c_2$ et $\hat{I}c_3$. Les décodeurs par transitions 47 et 48 fournissent des bits reçus et décodés $Id_0$ à $Id_3$.

Les équations de chaque décodeur différentiel 47, 48 sont dans le cas du codage par transitions donné précédemment pour l'émission :

$$A_i = (\overline{a_i}.\overline{b_i}.b_{i-1}) + (a_i.\overline{b_i}.\overline{a_{i-1}}) + (a_i.b_i.\overline{b_{i-1}}) + (\overline{a_i}.b_i.a_{i-1})$$

$$B_i = (\overline{a_i}.\overline{b_i}.a_{i-1}) + (a_i.\overline{b_i}.b_{i-1}) + (a_i.b_i.\overline{a_{i-1}}) + (\overline{a_i}.b_i.\overline{b_{i-1}})$$

Le codage/décodage par transitions permet de lever les ambiguïtés de phase de $\pm \pi/2$ et $\pi$ et le schéma proposé est donc transparent aux ambiguïtés de phase.

L'invention s'applique notamment à la transmission de données en MAQ-16 par faisceaux hertziens pour un débit transmis de l'ordre de 10 Mbits/s. Les données transmises sont intégrées dans des trames et il est donc possible d'effectuer une transmission en temps partagé (AMRT). Comme le nombre de bits de parité rajoutés au codage est fixe, la structure des trames présente également un rendement fixe.

La redondance ajoutée est très faible et donc le gain de codage maximal.

## Revendications

1. Système de codage/décodage utilisant la modulation MAQ-16 codée en blocs à multiniveaux, ledit système comprenant un émetteur et un récepteur de bits d'information utile,

   - ledit émetteur comprenant :

      - deux codeurs par transitions (11, 12) à deux dimensions chacun, un premier desdits codeurs (11) recevant deux bits d'information utile à transmettre ($I_0$, $I_1$), appelés bits de poids le plus fort, le deuxième desdits codeurs (12) recevant deux autres bits d'information utile à transmettre ($I_2$, $I_3$), appelés bits de poids le plus faible ;
      - deux codeurs de parité (13, 14) de rendement N/N-1, avec N pair, recevant les bits issus dudit premier codeur par transitions (11), lesdits codeurs de parité (13, 14) fournissant tous les N symboles lesdits bits issus dudit premier codeur par transitions (11) accompagnés d'une information de parité ;

- une unité (18) d'affectation d'un symbole du plan complexe de la constellation MAQ-16 à chaque groupe de quatre bits issus desdits codeurs de parité (13, 14) et dudit deuxième codeur par transitions (12), ladite unité d'affectation (18) fournissant sur deux voies d'émission les niveaux d'amplitude (I, Q) respectifs desdits symboles tout en respectant les règles suivantes :

  - tous les symboles d'un même quadrant dudit plan complexe ont les mêmes deux bits de poids le plus faible,
  - les deux bits de poids le plus fort des symboles présents dans le même quadrant et proches d'un même axe dudit plan complexe différent d'un seul bit, les symboles dudit plan complexe étant répartis en sous-ensembles ($\square$, $\bigcirc$, $\odot$, $\Delta$), chaque sous-ensemble présentant un couple de bits de poids le plus fort différent du couple de bits de poids le plus fort d'un autre sous-ensemble ;

- des moyens de modulation (19) en quadrature de phase desdits niveaux d'amplitude (I, Q) fournissant un signal à transmettre (ST) ;

- • ledit récepteur comprenant :

  - des moyens (41) de démodulation en quadrature de phase du signal reçu (SR), fournissant deux niveaux d'amplitude reçus (I, Q) ;
  - une unité de prédécision (42) qui réalise une décision ferme sur les niveaux d'amplitude reçus (I, Q) et qui, pour chacun desdits niveaux d'amplitude reçus (I, Q), calcule d'une part un coefficient de fiabilité ($f_i^I$, $f_i^Q$) égal à la différence en valeur absolue entre les distances euclidiennes carrées de chaque niveau d'amplitude reçu (I, Q) et le niveau d'amplitude correspondant au symbole idéal le plus proche dans la constellation MAQ-16, et qui fournit d'autre part une information de secteur (Sect_I, Sect_Q) permettant de définir dans lequel des trois secteurs délimités par des seuils de décision (SI$^-$, SI$^+$, SQ$^-$, SQ$^+$) correspondant à des niveaux d'amplitude idéaux attendus pour les quatre symboles les plus proches des deux axes de ladite constellation MAQ-16 le symbole reçu se situe ;
  - deux décodeurs de Wagner (43, 44) fonctionnant en décision souple et recevant chacun d'une part les décisions fermes correspondant auxdits bits de poids le plus fort ($\hat{I}_0$, $\hat{I}_1$) et d'autre part chacun l'un desdits coefficients de fiabilité ($f_i^I$, $f_i^Q$), lesdits décodeurs de Wagner (43, 44) fournissant tous les N symboles d'information lesdites décisions fermes ($\hat{I}_0$, $\hat{I}_1$) accompagnées d'une information de correction (Wagner_corr_I, Wagner_ corr_Q) indicatrice de la vérification de ladite information de parité ;
  - une unité de décision (45) recevant lesdites décisions fermes ($\hat{I}_0$ à $\hat{I}_3$), lesdites informations de correction (Wagner_corr_I, Wagner_corr_Q) et lesdites informations de secteur (Sect_I, Sect_Q), ladite unité de décision (45) corrigeant les deux bits de poids le plus fort ($\hat{I}_0$, $\hat{I}_1$) issus desdits décodeurs de Wagner (43, 44) en fonction desdites informations de correction (Wagner_corr_I, Wagner_corr_Q) et corrigeant les deux bits décidés de poids le plus faible ($\hat{I}_2$, $\hat{I}_3$) en fonction desdites informations de secteur (Sect_I, Sect_Q), des bits corrigés ($\hat{I}c_0$, $\hat{I}c_1$) de poids le plus fort et desdites informations de correction (Wagner_corr_I, Wagner_corr_Q) ;
  - deux décodeurs par transitions (47, 48) à deux dimensions chacun, un premier desdits décodeurs (47) recevant les deux bits corrigés de poids le plus fort ($\hat{I}c_0$, $\hat{I}c_1$), le deuxième desdits décodeurs (48) recevant les deux bits corrigés de le plus faible ($\hat{I}c_2$, $\hat{I}c_3$), lesdits décodeurs (47, 48) bits corriges de poids le plus faible ($\hat{I}c_2$, $\hat{I}c_3$), lesdits décodeurs (47, 48) fournissant des bits reçus et décodés (Id$_0$ à Id$_3$).

2. Système selon la revendication 1, caractérisé en ce que N est égal à 16.

# FIG. 1

# FIG. 2

# FIG. 3

△ U □ U O U ⊙

0                  1

△ U □                    O U ⊙

0      1                 0      1

△        □                  O        ⊙

# FIG. 4

# FIG. 5

Sect_Q = +1

Sect_Q = 0

Sect_Q = −1

Sect_I = −1    Sect_I = 0    Sect_I = +1

Office européen
des brevets

**RAPPORT DE RECHERCHE EUROPEENNE**

Numero de la demande

EP 96 40 2748

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | US 4 660 214 A (PAHLAVAN KAVEH ET AL) 21 Avril 1987 <br> * le document en entier * <br> --- | 1 | H03M13/00 <br> H04L27/34 |
| A | EP 0 616 454 A (PHILIPS ELECTRONIQUE LAB ;PHILIPS NV (NL)) 21 Septembre 1994 <br> * le document en entier * <br> --- | 1 | |
| A | WO 92 20162 A (QUALCOMM INC) 12 Novembre 1992 <br> --- | | |
| A | EP 0 610 648 A (NIPPON ELECTRIC CO) 17 Août 1994 <br> --- | | |
| A | EP 0 052 463 A (PLESSEY OVERSEAS) 26 Mai 1982 <br> --- | | |
| A | WO 93 06550 A (QUALCOMM INC) 1 Avril 1993 <br> --- | | |
| A | EP 0 392 538 A (TOKYO SHIBAURA ELECTRIC CO) 17 Octobre 1990 <br> --- | | DOMAINES TECHNIQUES RECHERCHES (Int.Cl.6) |
| A | EP 0 624 019 A (GEN INSTRUMENT CORP) 9 Novembre 1994 <br> --- | | H03M <br> H04L |
| A | JOURNAL OF THE ASSOCIATION FOR COMPUTING MACHINERY, JAN. 1974, USA, <br> vol. 21, no. 1, ISSN 0004-5411, <br> pages 168-173, XP000600172 <br> WAGNER R A ET AL: "The string-to-string correction problem" <br> ----- | | |

Le présent rapport a été établi pour toutes les revendications

| Lieu de la recherche | Date d'achèvement de la recherche | Examinateur |
|---|---|---|
| LA HAYE | 25 Mars 1997 | Devergranne, C |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...........................................................
& : membre de la même famille, document correspondant

EPO FORM 1503 03.82 (P04C02)